# FASCICULE DE BREVET EUROPEEN

(11) **EP 0 710 060 B1**
(45) Date de publication et mention de la délivrance du brevet: **20.01.1999**
(21) Numéro de dépôt: 94402443.9
(22) Date de dépôt: 28.10.1994
(51) Int. Cl.: H05K 3/12

(54) **Procédé de fabrication de cartes à support plastique, dispositif permettant la mise en oeuvre du prodédé ainsi que l'utilisation du procédé pour la fabrication de cartes à micro-circuits**
Verfahren zur Herstellung von Kunststoffkartenträgern, Anordnung zur Durchführung des Verfahrens und Anwendung des Verfahrens für die Produktion von Mikroschaltungskarten
Process for fabrication of plastic card supports, device for carrying out the process and application of the process for the production of micro circuit cards

(43) Date de publication de la demande: 01.05.1996
(73) Titulaire: GILLES LEROUX S.A., F-45470 Loury (FR); ATN, 45160 Olivet (FR)
(72) Inventeur: Chiloff, Serge, F-45160 Olivet (FR); Bernard, Jean-Marc, F-45380 La Chapelle St Mesmin (FR); Nioche, Gérard, F-45370 Clery St Andre (FR)
(74) Mandataire: Debay, Yves

(56) Documents cités:
- GB-A- 2 177 262
- US-A- 3 652 332
- US-A- 3 914 147

## Description

La présente invention concerne un procédé de fabrication des cartes à support plastique, le dispositif permettant la mise en oeuvre du procédé ainsi que l'utilisation du procédé pour la fabrication de cartes à micro-circuits.

Il est connu de fabriquer les supports en plastique pour cartes à micro-circuits selon un procédé multicouches ou selon un procédé monocouche.

Dans le procédé monocouche, les cartes sont fabriquées à partir de grandes plaques sur lesquelles une pluralité de cartes sont imprimées par un procédé d'impression offset puis chaque plaque est découpée en bandes et les bandes sont ensuite découpées pour former les supports plastiques ayant les dimension d'une carte.

Un tel procédé présente l'inconvénient de multiples opérations de reprise et de transport des plaques puis ensuite des bandes et enfin des cartes.

Il est connu un autre procédé dans lequel les cartes sont formées en multicouches à partir de trois rubans dont un premier constitue la couche de fond, un autre la couche centrale présentant des découpes régulièrement espacées pour mise en place du chip intégré et un troisième ruban constituant la couche supérieure qui comporte également des découpes régulièrement espacées pour permettre la mise en place du module de contact. Les trois couches une fois assemblées sont ensuite découpées aux dimensions d'une carte.

Ce procédé présente l'inconvénient d'être complexe au niveau de l'assemblage des différentes couches pour constituer le support en plastique et nécessite au préalable l'impression, soit sur la couche de fond, soit sur la couche supérieure ou sur les deux couches en même temps des motifs à faire figurer sur la carte. Ce procédé pose le problème de la coïncidence des motifs dans le cas d'une impression double face. En outre il ne permet pas d'obtenir des cadences de fabrication élevées.

Un premier but de l'invention est donc de proposer un procédé de fabrication de support plastique pour cartes à semi-conducteurs qui permette une fabrication des supports nécessitant un minimum d'opérations de reprise et de transport d'un poste à l'autre qui supprime le problème de coïncidence des motifs et qui permette également des cadences de fabrication élevées.

Ce but est atteint par le fait que le procédé de fabrication de cartes à support plastique est caractérisé en ce qu'il comporte les étapes suivantes :
- déroulement et redressage d'un ruban continu en matière plastique de dimension légèrement supérieure à une des dimensions de la carte ;
- impression dans au moins une station d'impression d'une succession de motifs d'impression et de repères imprimés dont chacun correspond au motif d'une carte dans au moins une couleur d'impression ;
- entraînement de la bande à une vitesse régulée correspondant à la vitesse d'impression et de découpage d'un poste de découpage situé en aval de la station d'impression ;
- détection de la différence entre la vitesse d'impression et la vitesse de découpage;
- découpage par une presse de la bande à des emplacements définis par les repères imprimés et à une cadence proche de la cadence maximale de la presse ;
- régulation de la vitesse d'impression en fonction de la différence de vitesse détectée entre la vitesse d'impression et la vitesse de découpage.

Selon une autre particularité, en sortie de l'opération d'impression et avant l'opération de découpage, le procédé comporte une opération de séchage.

Selon une autre particularité, l'opération de séchage est obtenue par deux tubes à ultraviolets disposés de part et d'autre de la bande pour une impression double face.

Selon une autre particularité, le procédé de fabrication du support plastique comporte une étape de dépôt d'une couche de vernis pour protéger l'impression avant l'étape de séchage par ultraviolets.

Selon une autre particularité, le procédé de fabrication du support en matière plastique comporte une étape de dépose d'une couche de protection sur chacune des faces imprimées.

Un autre but de l'invention est de proposer un dispositif de fabrication permettant la mise en oeuvre du procédé.

Ce but est atteint par le dispositif selon la revendication 6.

Selon une autre particularité, chaque station d'impression comporte au moins un dispositif d'impression formé d'un rouleau d'encrage entraînant un rouleau porte-plaque en contact avec un blanchet, le rouleau d'encrage coopérant avec un rouleau de laminage de la pellicule d'encre sur le rouleau d'encrage en fonction de la vitesse relative du rouleau d'encrage et du rouleau de laminage, chaque rouleau ayant une largeur correspondant approximativement à une des dimensions de la carte, le rouleau blanchet étant en contact avec un côté de la bande.

Selon une autre particularité, chaque station d'impression comporte de chaque côté de la bande un dispositif d'impression constitué d'un rouleau d'encrage entraînant un rouleau porte plaque en contact avec un blanchet, le rouleau d'encrage coopérant avec un rouleau de laminage de la pellicule d'encre sur le rouleau d'encrage en fonction des vitesses relatives du rouleau d'encrage et du rouleau de laminage, chaque rouleau ayant une largeur correspondant approximativement à une des dimensions de la carte, les deux rouleaux blanchets de chaque côté de la bande étant en contact avec celle-ci.

Selon une autre particularité, la presse comporte un ensemble matrice poinçon, le poinçon monté sur des colonnes est entraîné en déplacement par un système bielle manivelle excentrique, la bande étant entraînée par un ensemble formé d'un rouleau moteur et d'un rouleau presseur de façon à amener le repère imprimé en vis-à-vis d'une cellule photo-électrique disposée dans la matrice.

Selon une autre particularité, l'entraînement de la bande est assuré par deux rouleaux dont au moins un est moleté sur ses deux extrémités sur une distance correspondant à la marge séparant le bord de la bande du bord de la découpe délimitant la carte.

Selon une autre particularité, la station d'impression fonctionne à une vitesse inférieure à 20m/s.

Selon une autre particularité, la presse de découpage fonctionne à une cadence comprise entre 7000 et 13000 cartes par heure.

Un autre but de l'invention est de proposer l'utilisation du procédé pour la fabrication de cartes à micro-circuits.

Ce but est atteint par le procédé selon la revendication 13.

Selon une autre particularité, le procédé comporte une étape de comptage par caméra et une étape de mise en barquettes.

D'autres caractéristiques et avantages de la présente invention apparaîtront plus clairement à la lecture de la description ci-après faite en référence aux dessins annexés dans lesquels :
- la figure 1 représente une vue d'ensemble du procédé de fabrication de support plastique ;
- la figure 2A représente une vue de face du dispositif de découpe utilisé dans le procédé de la figure 1 ;
- la figure 2B représente une vue en coupe du système d'entraînement, des poinçons et matrices de la presse de découpe ;
- la figure 3 représente une seconde variante de procédé de fabrication de supports plastiques utilisée avec une chaîne d'insertion des modules dans les supports plastiques.

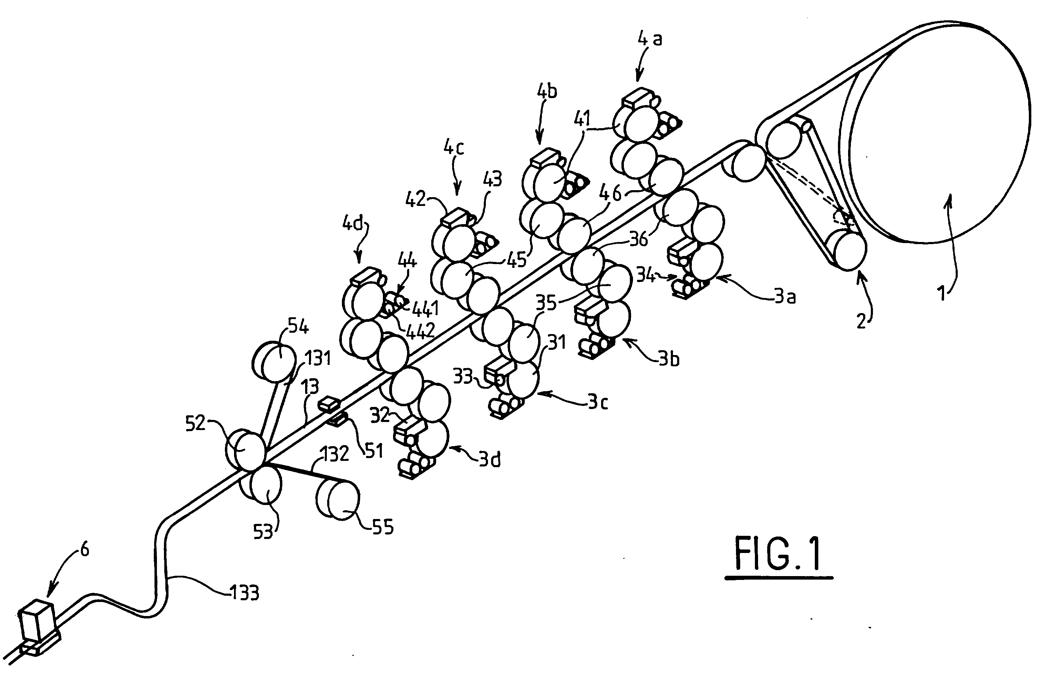

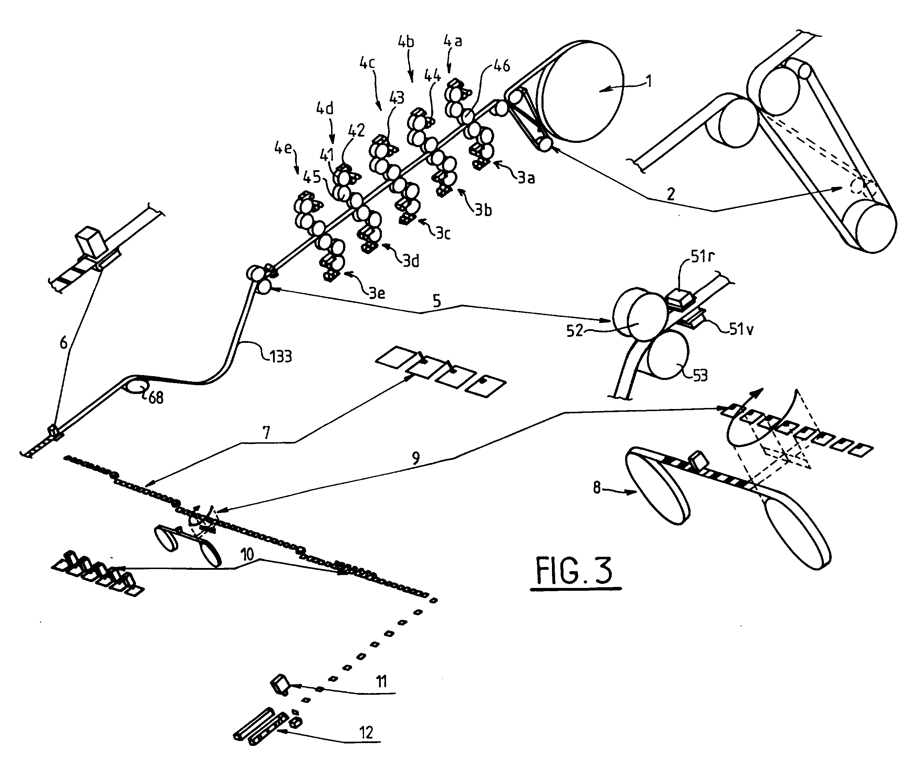

La figure 1 représente la partie de dispositif formant l'impression sur le support plastique dans le procédé de fabrication des supports plastiques qui est utilisé à la figure 3 en association avec une chaîne d'insertion de modules.

Le dispositif d'impression de la figure 1 est constitué d'un rouleau (1) supportant une bande (13) en PVC de l'épaisseur souhaitable pour le support plastique d'une carte et de largeur correspondant aux dimensions en largeur ou en longueur d'une carte. Ce rouleau (1) débite son ruban (13) dans un dispositif (2) de redressement de la bande de façon à supprimer la courbure résiduelle que celle-ci pourrait conserver à la suite du stockage en rouleau. La bande (13) traverse ensuite un ensemble de postes d'impression (4a, 4b, 4c, 4d) associé dans le cas où l'impression se fait sur deux faces avec des postes d'impression situés en vis-à-vis respectivement (3a, 3b, 3c, 3d). Chaque poste d'impression est constitué d'un encrier (42), respectivement (32), associé à un rouleau de laminage de l'encre (43), respectivement (33), et à un rouleau encreur (41), respectivement (31). Le rouleau encreur pénétrant dans l'encrier se recouvre d'encre et le rouleau de laminage (43 ou 33) permet par réglage de sa vitesse de déterminer l'épaisseur de la pellicule uniformément répartie sur le rouleau encreur (41), respectivement (31). Ce rouleau encreur coopère avec un rouleau porte-plaque (45), respectivement (35) qui porte les plaques sur lesquelles les motifs à imprimer ont été gravés. Les motifs à imprimer correspondent aux motifs à faire figurer sur chacune des faces de la carte dans la couleur correspondant à la station d'impression. Au rouleau d'encrage (41), respectivement (31) est associé un dispositif de mouillage (44), respectivement (34), constitué de deux rouleaux (441, 442), respectivement (341, 342) trempant dans un bac rempli de liquide mouilleur et dont l'un (442), respectivement (342) est en contact avec le rouleau d'encrage (41), respectivement (31). Ensuite le motif est transféré sur le ruban en PVC (13) à l'aide d'un rouleau blanchet (46) et respectivement (36), pour le dispositif d'impression sur la face inférieure. Il est bien évident que dans le cas où l'impression ne se fait que sur une seule face, chaque station d'impression ne comportera que le dispositif d'impression correspondant à la face qui doit être imprimée et sur la face opposée sans motif on utilisera simplement un rouleau de contre-pression. L'ensemble du dispositif d'impression est représenté avec quatre stations de façon à faire figurer les différentes couleurs de base permettant l'impression des différents motifs de couleur différente. Sur au moins une station d'impression au moins un des rouleaux porte-plaque comporte en plus du motif à imprimer la gravure d'un repère imprimé qui permet de repérer la position du motif formant la carte.

En sortie de la station du dispositif d'impression, le ruban (13) imprimé est soumis à une opération de séchage réalisée à l'aide de deux lampes à rayonnement à ultraviolets (51), l'une (51R) pour la face recto, l'autre (51V) pour la face verso de la bande (13) dans le cas où il y a une impression double face. Si l'impression se fait simplement sur la face recto, seule la lampe à UV (51R) sera utilisée.

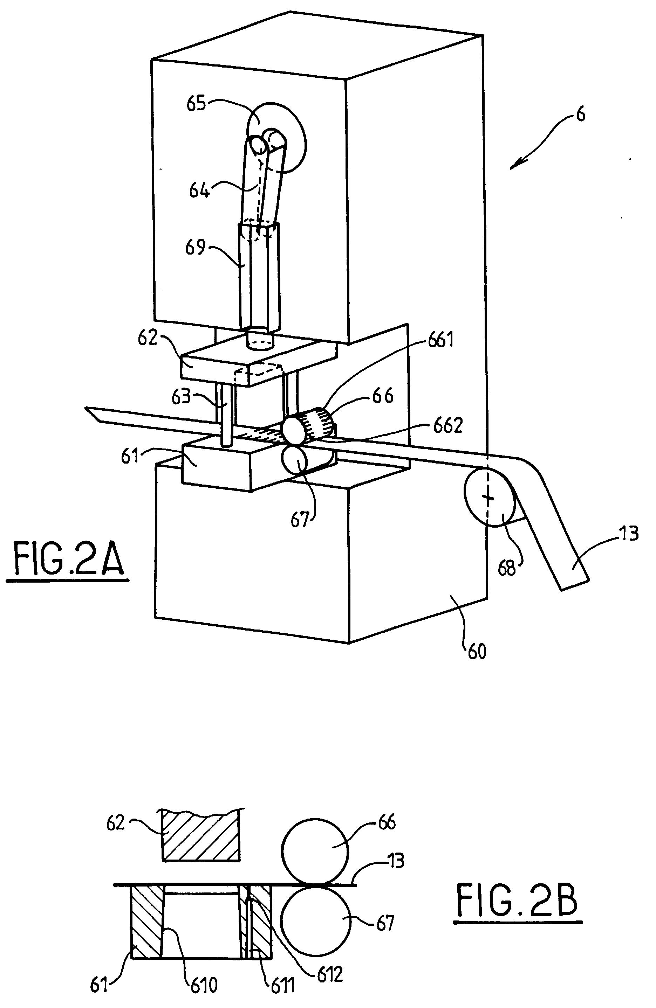

Dans une première variante de réalisation, le dispositif de séchage est suivi d'un ensemble de quatre rouleaux, deux (52, 53) coopérant avec la bande par friction pour entraîner celle-ci et assurer son entraînement entre le dispositif de redressement et la sortie du dispositif d'impression. Dans la première variante, la bande (13) imprimée reçoit également sur chacune de ses faces deux couches de ruban (131, 132) qui seront soudées ou collées par ultrason et qui constituent des couches de protection "overlay". Ces rubans (131, 132) sont débités à partir de deux bobines (54, 55) situées de part et d'autre de la bande (13) dans le cas où celle-ci est imprimée en double face. Si la bande est imprimée sur une seule face, seule la bobine correspondant au côté imprimé sera maintenue sur le dispositif. En sortie de la station d'entraînement (52, 53) , le ruban (13) constitue, comme comme figuré à la figure 1, une boucle (133) qui permet de déterminer l'avance ou le retard de la station d'impression par rapport à la station de découpage (6). A la station de découpage, la bande (13) est découpée en carte, comme on l'explicitera ci-après à la lumière de la figure 2.

Dans une autre variante de réalisation de la station d'impression, représentée à la figure 3, à la succession de stations (4a à 4d) constituant les dispositifs d'impression pour les couleurs nécessaires au motif est ajoutée une station supplémentaire (4e), respectivement (3e), qui permet le dépôt sur chacune des faces imprimées d'une pellicule de vernis jouant le rôle de protecteur pour l'impression.

La station de découpage (6) représentée aux figures 2A et 2B est constituée d'un support (60) sur lequel est montée une matrice (61) comportant des colonnes (63) sur lesquelles coulisse un poinçon (62) actionné par un ensemble bielle (69), manivelle (64), excentrique (65) entraîné en permanence par un moteur. Dans le corps de la matrice (61), un passage (611) permet la mise en place d'un dispositif photo-électrique (612) assurant la détection des repères imprimés imprimés à proximité de chaque motif représentatif de la carte. La détection du repère assure la mise en place de motifs en vis-à-vis du poinçon pour permettre la découpe à la volée et déclenche l'arrêt de l'entraînement de la bande (13) qui est assuré par deux rouleaux (66, 67) avant la descente du poinçon (62). Au moins un de ces deux rouleaux (66, 67) comporte sur sa bordure un moletage (661, 662) qui vient créer un moletage correspondant sur le bord de la bande. La dimension de ce moletage et la dimension de la bande (13) sont prévues pour que les parties moletées ne soient pas dans la surface qui constituera par la suite la carte et qui sera découpée dans la station de découpage (6), figurée à la figure 1. Un rouleau (68) disposé en amont des deux rouleaux d'entraînement (66, 67) est soit associé avec un bras pantographique et un système de détection électrique à contact, soit associé avec un système photo-électrique, pour permettre de détecter la dimension de la boucle (133) formée sur le ruban (13) entre la sortie du dispositif de séchage et l'entrée dans le dispositif de découpe (6) du procédé de fabrication. En fonction de la dimension de cette boucle (133), la vitesse d'impression sera accélérée ou ralentie. Lorsque la boucle (133) augmente, la vitesse d'impression va augmenter et lorsque la boucle (133) arrive en dessous d'une certaine valeur, la vitesse des stations (3, 4) d'impression est diminuée. Ceci permet d'adapter la vitesse d'impression à la vitesse de découpe de l'outil (6) qui peut atteindre une cadence de 10 à 11.000 cartes à l'heure alors que le dispositif d'impression peut atteindre une vitesse de 20m/s, ce qui nécessiterait un outil ayant des cadences nettement supérieures.

Les cartes découpées en sortie de la presse (6) sont rassemblées en lots et transférées sur une chaîne de montage des ensembles modulaires, comme représenté à la figure 3. Cette chaîne de montage des modules a une cadence de l'ordre de 3.000 cartes à l'heure. Il est donc souhaitable de disposer de plusieurs chaînes en parallèle. Chacune des chaînes comprendra un dispositif de fraisage des logements (7) dans lequel un ensemble de fraisage du type de celui décrit dans la demande de brevet 93 04072 déposée au nom de Gilles LEROUX S.A. est utilisé. Cette opération est suivie d'une opération de pré-encodage (8) de la puce. Puis la puce est placée sur un support modulaire, découpée, puis encartée, comme représentée à l'étape 9. La carte pourvue de son module de circuit intégré est ensuite amenée à un ensemble d'encodage et de contrôle (10) puis est transportée sur un tapis pour passer devant une caméra de comptage (11) et ensuite être rassemblée en barquettes au poste (12).

On comprend que par l'utilisation du système d'impression spécifique et de l'outil de découpage associé avec l'outil d'encartage des microcircuits décrit ci-dessus on arrive à obtenir des cadences de fabrication élevées, de l'ordre de 10 à 11.000 cartes par heure dans le cas où l'on utilise plusieurs chaînes d'encartage de puces en parallèle alimentées par la même chaîne de fabrication des supports plastiques.

## Revendications

1. Procédé de fabrication de cartes à support plastique caractérisé en ce qu'il comporte les étapes suivantes :
- déroulement et redressage d'un ruban continu en matière plastique de dimension légèrement supérieure à une des dimensions de la carte ;
- impression dans au moins une station d'impression (4a à 4d) d'une succession de motifs d'impression et de repères imprimés dont chacun correspond au motif d'une carte dans au moins une couleur d'impression ;
- entraînement de la bande (13) à une vitesse régulée correspondant à la vitesse d'impression et de découpage d'un poste de découpage (6) situé en aval de la station d'impression ;
- détection de la différence entre la vitesse d'impression et la vitesse de découpage ;
- découpage par une presse (6) de la bande à des emplacements définis par les repères imprimés et à une cadence proche de la cadence maximale de la presse ;
- régulation de la vitesse d'impression en fonction de la différence de vitesse détectée entre la vitesse d'impression et la vitesse de découpage.

2. Procédé selon la revendication 1, caractérisé en ce qu'en sortie de l'opération d'impression et avant l'opération de découpage, le procédé comporte une opération de séchage (51).

3. Procédé selon la revendication 2, caractérisé en ce que l'opération de séchage est obtenue par deux tubes à ultraviolets (51r, 51v) disposés de part et d'autre de la bande (13) pour une impression double face.

4. Procédé de fabrication du support plastique selon une des revendications 1 à 3, caractérisé en ce qu'il comporte une étape de dépôt d'une couche de vernis (4e) pour protéger l'impression avant l'étape de séchage (51) par ultraviolets.

5. Procédé de fabrication du support en matière plastique selon une des revendications 1 à 3, caractérisé en ce qu'il comporte une étape de dépose d'une couche de protection (131, 132) sur chacune des faces imprimées.

6. Dispositif de fabrication permettant la mise en oeuvre du procédé selon une des revendications précédentes, comprenant une bobine support (1) d'une bande (13) en matière plastique pour entraîner en rotation et débite la bande (13) sur un dispositif redresseur (2), ledit dispositif redresseur entraîne la bande (13) vers au moins une station d'impression (4, 3) ladite station d'impression à la sortie de laquelle est disposée une station de séchage (51) associée à des moyens d'entraînement de la bande (52, 53) et des moyens de détection de la différence de vitesse entre la vitesse d'impression et la vitesse de découpage d'une station de découpage (6) située en aval.

7. Dispositif selon la revendication 6, caractérisé en ce que chaque station d'impression comporte au moins un dispositif d'impression formé d'un rouleau d'encrage entraînant un rouleau porte-plaque (45) en contact avec un blanchet (46), le rouleau d'encrage (41) coopérant avec un rouleau de laminage (43) de la pellicule d'encre sur le rouleau d'encrage en fonction de la vitesse relative du rouleau d'encrage et du rouleau de laminage, chaque rouleau (41 à 46) ayant une largeur correspondant approximativement à une des dimensions de la carte, le rouleau blanchet (46) étant en contact avec un côté de la bande (13).

8. Dispositif selon la revendication 6, caractérisé en ce que chaque station d'impression comporte de chaque côté de la bande (13) un dispositif d'impression constitué d'un rouleau d'encrage (41, 31) entraînant un rouleau porte plaque (45, 35) en contact avec un blanchet (46, 36), le rouleau d'encrage (41, 31) coopérant avec un rouleau de laminage (43, 33) de la pellicule d'encre sur le rouleau d'encrage (41, 31) en fonction des vitesses relatives du rouleau d'encrage et du rouleau de laminage, chaque rouleau ayant une largeur correspondant approximativement à une des dimensions de la carte, les deux rouleau blanchets (46, 36) de chaque côté de la bande étant en contact avec celle-ci.

9. Dispositif selon une des revendications 6 à 8, caractérisé en ce que la presse comporte un ensemble matrice (61), poinçon (62), le poinçon (62) monté sur des colonnes est entraîné en déplacement par un système bielle (69), manivelle (64), excentrique (65), la bande (13) étant entraînée par un ensemble formé d'un rouleau moteur (67) et d'un rouleau presseur (66) de façon à amener un repère imprimé en vis-à-vis d'une cellule photo-électrique (612) disposée dans la matrice (61).

10. Dispositif selon la revendication 9, caractérisé en ce que l'entraînement de la bande (13) est assuré par deux rouleaux (66, 67) dont au moins un (66) est moleté sur ses deux extrémités sur une distance correspondant à la marge séparant le bord de la bande (13) du bord de la découpe délimitant la carte.

11. Dispositif selon la revendication 10, caractérisé en ce que la station d'impression fonctionne à une vitesse inférieure à 20m/seconde.

12. Dispositif selon la revendication 10, caractérisé en ce que la presse de découpage fonctionne à une cadence comprise entre 7000 et 13000 cartes par heure.

13. Utilisation du procédé de fabrication des cartes à support selon la revendication 1 pour la fabrication de carte à micro-circuits dans lequel les cartes découpées sont reprises sur une ou plusieurs chaînes d'insertion de modules fonctionnant à une cadence inférieure à la cadence de fabrication des supports plastiques pour effectuer les étapes suivantes :
- fraisage du logement (7) ;
- pré-encodage (8) des microcircuits à semiconducteurs ;
- découpe et encartage des modules (9) formés d'un circuit à semi-conducteurs monté sur un support formant des plages de contact ;
- encodage (10) et contrôle des cartes.

14. Utilisation du procédé de fabrication selon la revendication 13, caractérisée en ce que le procédé comporte une étape de comptage (11) par caméra et une étape de mise en barquettes (12).

## Patentansprüche

1. Verfahren zur Herstellung von Karten mit Kunststoffträger, dadurch gekennzeichnet, daß es folgende Schritte enthält:
- Abwickeln und Geradebiegen eines Endlosbandes aus Kunststoff, dessen Abmessung geringfügig größer als eine der Abmessungen der Karte ist;
- Aufdrucken, in mindestens einer Druckstation (4a bis 4d), einer Folge von Druckmotiven und gedruckten Markierungen, von denen jede dem Motiv einer Karte in mindestens einer Druckfarbe entspricht;
- Antreiben des Bandes (13) mit einer geregelten Geschwindigkeit, die der Druck- und der Stanzgeschwindigkeit einer nach der Druckstation angeordneten Stanzstation (6) entspricht;
- Erfassen des Unterschieds zwischen der Druckgeschwindigkeit und der Stanzgeschwindigkeit;
- Ausstanzen des Bandes mit einer Presse (6) an Stellen, die durch die gedruckten Markierungen festgelegt sind, und in einem Takt, der nahe dem maximalen Takt der Presse ist;
- Regeln der Druckgeschwindigkeit in Abhängigkeit vom erfaßten Geschwindigkeitsunterschied zwischen der Druckgeschwindigkeit und der Stanzgeschwindigkeit.

2. Verfahren nach Anspruch 1, dadurch gekennzeichnet, daß das Verfahren nach dem Druckvorgang und vor dem Stanzvorgang einen Trockenvorgang (51) enthält.

3. Verfahren nach Anspruch 2, dadurch gekennzeichnet, daß der Trockenvorgang durch zwei Ultraviolett-Röhren (51r, 51v) erhalten wird, die bei einem doppelseitigen Druck auf der einen und der anderen Seite des Bandes (13) angeordnet sind.

4. Verfahren zur Herstellung eines Kunststoffträgers nach einem der Ansprüche 1 bis 3, dadurch gekennzeichnet, daß es einen Schritt des Auftragens einer Lackschicht (4e) enthält, um den Druck vor dem Schritt des Ultraviolett-Trocknens (51) zu schützen.

5. Verfahren zur Herstellung eines Kunststoffträgers nach einem der Ansprüche 1 bis 3, dadurch gekennzeichnet, daß es einen Schritt zum Auftragen einer Schutzschicht (131, 132) auf jede der bedruckten Flächen enthält.

6. Vorrichtung zum Ausführen des Verfahrens nach einem der vorangehenden Ansprüche, mit einer Trägerspule (1) für ein Band (13) aus Kunststoff, um das Band anzudrehen und einer Vorrichtung (2) zum Geradebiegen zu liefern, wobei die Vorrichtung zum Geradebiegen das Band (13) mindestens einer Druckstation (4, 3) liefert, nach welcher eine Trockenstation (51) angeordnet ist, der Mittel (52, 53) zum Antreiben des Bandes und Mittel zum Erfassen des Geschwindigkeitsunterschieds zwischen der Druckgeschwindigkeit und der Stanzgeschwindigkeit einer nachfolgend angeordneten Stanzstation (6) zugeordnet sind.

7. Vorrichtung nach Anspruch 6, dadurch gekennzeichnet, daß jede Druckstation mindestens eine Druckvorrichtung enthält, die aus einer Farbwalze besteht, die eine mit einer Gummiwalze (46) in Kontakt stehende Plattenträger-Walze (45) antreibt, wobei die Farbwalze (41) mit einer Walze (43) zum Andrücken der Farbschicht auf die Farbwalze in Abhängigkeit von der Relativgeschwindigkeit der Farbwalze und der Farbandruck-Walze zusammenwirkt, wobei die Breite jeder Walze (41 bis 46) in etwa einer der Abmessungen der Karte entspricht, wobei die Gummiwalze (46) mit einer Seite des Bandes (13) in Kontakt steht.

8. Vorrichtung nach Anspruch 6, dadurch gekennzeichnet, daß jede Druckstation auf jeder Seite des Bandes (13) eine Druckvorrichtung enthält, die aus einer Farbwalze (41, 31) besteht, die eine mit einer Gummiwalze (46, 36) in Kontakt stehende Plattenträger-Walze (45, 35) antreibt, wobei die Farbwalze (41, 31) mit einer Walze (43, 33) zum Andrücken der Farbschicht auf die Farbwalze (41, 31) in Abhängigkeit von der Relativgeschwindigkeit der Farbwalze und der Farbandruck-Walze zusammenwirkt, wobei die Breite jeder Walze in etwa einer der Abmessungen der Karte entspricht, wobei die beiden Gummiwalzen (46, 36) auf der einen und der anderen Seite des Bandes mit diesem in Kontakt stehen.

9. Vorrichtung nach einem der Ansprüche 6 bis 8, dadurch gekennzeichnet, daß die Presse eine Einheit aus Matrize (61) und Stempel (62) enthält, daß der auf Säulen angebrachte Stempel (62) von einer Einrichtung aus einem Schwingarm (69), einer Kurbel (64) und einem Exzenter (65) verschieblich angetrieben ist, wobei das Band von einer Einheit aus einer Antriebswalze (67) und einer Andrückwalze (66) angetrieben ist, so daß eine gedruckte Markierung gegenüber einer in der Matrize (61) angeordneten photoelektrischen Zelle (612) gebracht wird.

10. Vorrichtung nach Anspruch 9, dadurch gekennzeichnet, daß das Antreiben des Bandes (13) von zwei Walzen (66, 67) gewährleistet ist, von welchen mindestens eine (66) an ihren beiden Enden über eine Länge gerändelt ist, der dem Bereich entspricht, der den Rand des Bandes (13) vom Rand des die Karte begrenzenden Ausschnitts trennt.

11. Vorrichtung nach Anspruch 10, dadurch gekennzeichnet, daß die Druckstation mit einer Geschwindigkeit von unter 20 m/Sekunde arbeitet.

12. Vorrichtung nach Anspruch 10, dadurch gekennzeichnet, daß die Stanzpresse in einem Takt zwischen 7000 und 13000 Karten pro Stunde arbeitet.

13. Verwendung des Verfahrens zur Herstellung der Trägerkarten nach Anspruch 1 für die Herstellung einer Karte mit Mikroschaltungen, in welchem die ausgestanzten Karten in einer oder mehreren Fertigungsstraßen zum Einsetzen von Modulen übernommen werden, die in einem Takt arbeitet bzw. arbeiten, der niedriger ist als der Takt zur Herstellung der Kunststoffträger, um folgende Schritte auszuführen:
- Fräsen der Aufnahme (7);
- Vorcodieren (8) der Halbleiter-Mikroschaltungen;
- Stanzen und Einsetzen der aus einer Halbleiterschaltung gebildeten Modulen (9) in die Karten, wobei die Halbleiterschaltung auf einem Träger angebracht ist, der Kontaktflächen bildet;
- Codieren (10) und Kontrollieren der Karten.

14. Verwendung des Herstellungsverfahrens nach Anspruch 13, dadurch gekennzeichnet, daß das Verfahren einen Schritt (11) des Zählens mittels einer Kamera und einen Schritt (12) des Einsetzens in Behälter enthält.

## Claims

1. Method of manufacturing cards with a plastic base characterised in that it comprises the following steps:
- unwinding and straightening of a continuous strip of plastic material, slightly greater in dimension than one of the dimensions of the card;
- printing in at least one printing station (4a to 4d) of a succession of printing patterns and printed marks, each of which corresponds to the pattern of a card in at least one printing colour;
- driving of the strip (13) at a regulated speed corresponding to the printing speed, and cutting by a cutting post (6) located downstream of the printing station;
- detection of the difference between the printing speed and the cutting speed;
- cutting by a press (6) of the strip at locations defined by the printed marks and at a rate close to the maximum rate of the press;
- regulation of the printing speed as a function of the difference in speed detected between the printing speed and the cutting speed.

2. Method according to Claim 1, characterised in that, at the outlet of the printing operation and before the cutting operation, the method comprises a drying operation (51).

3. Method according to Claim 2, characterised in that the drying operation is achieved by two ultraviolet tubes (51r, 51v) arranged on either side of the strip (13) for double-sided printing.

4. Method for manufacturing the plastic base according to one of Claims 1 to 3, characterised in that it comprises a step of depositing a coat of varnish (4e) to protect the printing before the step of drying (51) by ultraviolet.

5. Method of manufacturing the base made of plastic material according to one of Claims 1 to 3, characterised in that it comprises a step of depositing a protective coat (131, 132) on each of the printed faces.

6. Manufacturing device allowing implementation of the method according to one of the preceding claims, comprising a support reel (1) for a strip (13) made of plastic material in order to drive in rotation and feed the strip (13) over a straightening device (2), said straightening device drives the strip (13) towards at least one printing station (4, 3), at the outlet from which printing station there is a drying station (51) associated with means for driving the strip (52, 53) and means for detecting the difference in speed between the printing speed and the cutting speed of a cutting station (6) located downstream.

7. Device according to Claim 6, characterised in that each printing station comprises at least one printing device formed of an ink roller driving a plate-holder roller (45) in contact with a blanket (46), the ink roller (41) cooperating with a roller (43) for laminating the film of ink on the ink roller as a function of the relative speed of the ink roller and the lamination roller, each roller (41 to 46) having a width corresponding approximately to one of the dimensions of the card, the blanket roller (46) being in contact with one side of the strip (13).

8. Device according to Claim 6, characterised in that each printing station comprises, on either side of the strip (13), a printing device constituted by an ink roller (41, 31) driving a plate-holder roller (45, 35) in contact with a blanket (46, 36), the ink roller (41, 31) co-operating with a roller (43, 33) for laminating the film of ink on the ink roller (41, 31) as a function of the relative speeds of the ink roller and the lamination roller, each roller having a width corresponding approximately to one of the dimensions of the card, the two blanket rollers (46, 36) of each side of the strip being in contact therewith.

9. Device according to one of Claims 6 to 8, characterised in that the press comprises a die (61) / punch (62) assembly, the punch (62) mounted on columns is driven in displacement by a connecting rod (69) / crank (64) / eccentric (65) system, the strip (13) being driven by an assembly formed by a drive roller (67) and a pressure roller (66) so as to bring a printed mark to face a photo-electric cell (612) arranged inside the die (61).

10. Device according to Claim 9, characterised in that the strip (13) is driven by two rollers (66, 67), at least one of which (66) is milled on both its ends over a distance corresponding to the margin separating the edge of the strip (13) from the edge of the cut delimiting the card.

11. Device according to Claim 10, characterised in that the printing station operates at a speed of less than 20 m per second.

12. Device according to Claim 10, characterised in that the cutting press operates at a rate of between 7,000 and 13,000 cards per hour.

13. Use of the method of manufacturing cards with a base according to Claim 1 for the manufacture of microcircuit cards in which the cut cards are collected on one or more module-insertion lines operating at a rate less than the rate of manufacturing the plastic bases in order to carry out the following steps:
- countersinking of the housing (7);
- pre-encoding (8) of the semiconductor microcircuits;
- cutting and inserting of the modules (9) formed by a semiconductor circuit mounted on a base forming contact areas;
- encoding (10) and checking of the cards.

14. Use of the manufacturing method according to Claim 13, characterised in that the method comprises a step of counting (11) by a camera and a step of putting into trays (12).
